# EUROPÄISCHE PATENTSCHRIFT

(11) **EP 3 245 665 B1**
(45) Veröffentlichungstag und Bekanntmachung des Hinweises auf die Patenterteilung: **05.07.2023**
(21) Anmeldenummer: 16700464.7
(22) Anmeldetag: 13.01.2016
(51) Int. Cl.: H01L 21/02, B28D 5/00, B23K 26/0622, B23K 26/53, B28D 1/22, B23K 103/00

(54) **VERFAHREN ZUM HERSTELLEN EINES UNEBENEN WAFERS**
METHOD FOR PRODUCING A NONPLANAR WAFER
PROCÉDÉ POUR FABRIQUER UNE TRANCHE IRRÉGULIÈRE

(30) Priorität: 15.01.2015 DE 102015000451
(43) Veröffentlichungstag der Anmeldung: 22.11.2017
(60) Teilanmeldung: 23167033.2
(73) Patentinhaber: Siltectra GmbH, 01099 Dresden (DE)
(72) Erfinder: RICHTER, Jan, 01109 Dresden (DE)
(74) Vertreter: Westphal, Mussgnug & Partner, Patentanwälte mbB
(86) Internationale Anmeldenummer: PCT/EP2016/050574
(87) Internationale Veröffentlichungsnummer: WO 2016/113309

(56) Entgegenhaltungen:
- EP-A1- 3 137 657
- WO-A1-2014/177716
- US-A1- 2010 330 777
- US-A1- 2013 089 969
- US-A1- 2013 316 538
- US-A1- 2014 038 392

## Beschreibung

Die vorliegende Erfindung bezieht sich gemäß Anspruch 1 auf ein Verfahren zum Abtrennen von mindestens einem Festkörperanteil von einem Festkörper Wafer sind in der Regel Festkörperteile, die von einem Festkörper abgetrennt wurden. Sie erstrecken sich im Wesentlichen zweidimensional, d.h. ihre Dicke ist gegenüber ihrer Breite und Länge um mindestens eine Größenordnung kleiner. Wafer werden bevorzugt in der Halbleitertechnik zur Herstellung von Solarzellen, Computerchips, LEDs, etc. verwendet. Die Erzeugung von Wafern ist sehr kostenintensiv, wodurch versucht wird möglichst viele Wafer aus einem Festkörper zu gewinnen. Dies führt dazu, dass die Wafer im dünner werden, was wiederum dazu führt, dass sie sich nach einer Beschichtung verformen, wenn die Temperaturausdehnungskoeffizienten der Beschichtung und des Wafers variieren. Eine solche Verformung wird als Warp bezeichnet, der eine Wölbung des Wafers beschreibt. Derartige Wölbungen werden z.B. durch die Druckschriften EP0966047A2, US6528394, US6829270, US7315045 und US7592629, deren Gegenstände durch Bezugnahme zum Gegenstand der vorliegenden Schutzrechtsschrift gemacht werden, beschrieben. Die Verformungen des Wafers führen dazu, dass die erzeugte Mehrschichtanordnung nicht optimal bearbeitbar ist oder dass sie nicht nur begrenzt mit Kräften belastbar ist oder dass sie sich in Höhenrichtung weiter erstreckt als unbedingt erforderlich.

Die US 2014 / 038392 A1 beschreibt ein Verfahren zum Abtrennen einer Schicht eines kristallinen Halbleitermaterials von einem dickeren Wafer unter Verwendung von Laserstrahlen. Die abgetrennte Schicht umfasst beispielsweise ein optisches, photovoltaisches, elektronisches, oder mikroelektronisch-mechanisches System.

Die EP 3 137 657 A0 (WO 2015 165552 A1) beschreibt ein Verfahren zum Abtrennen einer dreidimensionalen Festkörperschicht von einem Festkörper. Das Verfahren umfasst das Herstellen einer Defektschicht mittels eines Laserstrahls innerhalb des Festkörpers und das Ablösen der Festkörperschicht entlang der Defektschicht von dem Festkörper.

Es ist die Aufgabe der vorliegenden Erfindung eine Lösung bereitzustellen, durch welche die zuvor genannten Mehrschichtanordnungen mit geringeren Warps oder ohne Warps hergestellt werden können.

Die zuvor genannte Aufgabe wird erfindungsgemäß durch ein Verfahren nach Anspruch 1 gelöst.

Diese Lösung ist vorteilhaft, da der Festkörperanteil bevorzugt derart erzeugt wird, dass er infolge der späteren Bearbeitung die gewünschte Form annimmt. Es wird somit in Abhängigkeit der Materialeigenschaften des Festkörperanteils und der Beschichtung der Festkörperanteil mit einer Form erzeugt, durch welche die aus der Beschichtung resultierende Verformung ausgenutzt wird, um eine zumindest einerseits und bevorzugt beiderseits bevorzugt ebene oder im Wesentlichen ebene Oberfläche der Mehrschichtanordnung zu schaffen.

Weitere vorteilhafte Ausführungsformen sind Gegenstand der nachfolgenden Beschreibung und/oder der Unteransprüche.

Die Modifikationen werden gemäß der vorliegenden Erfindung innerhalb des Kristallgitters des Festkörpers mittels über eine äußere Oberfläche des Festkörperanteils in das Innere des Festkörperanteils eingeleitete Strahlung von mindestens einem Laser, insbesondere einem Piko- oder Femtosekunden-Laser, erzeugt. Zusätzlich ist denkbar, dass die Modifikationen in dem Kristallgitter durch Ionenimplantation erzeugt werden. Diese Ausführungsform ist vorteilhaft, da mittels Laserstrahlung und Ionenimplantation sehr genau Modifikationen erzeugt werden können. Der Ablösebereich kann somit sehr einfach in Abhängigkeit von den jeweiligen Parametern erzeugt werden.

Die einzelnen Modifikationen bzw. Defekte bzw. Schadstellen resultieren gemäß einer weiteren bevorzugten Ausführungsform der vorliegenden Erfindung jeweils aus einer von dem Laser, insbesondere einem Femtosekunden-Laser oder einem Pikosekunden-Laser, bewirkten multi-photonen Anregung. Bevorzugt hat der Laser eine Pulsdauer von unter 10ps, besonders bevorzugt unter 1ps und am höchsten bevorzugt von unter 500fs.

Gemäß einer weiteren bevorzugten Ausführungsform der vorliegenden Erfindung wird die Energie des Laserstrahls, insbesondere des fs-Lasers, derart gewählt, dass die Schädigungsausbreitung im Festkörper bzw. im Kristall kleiner als dreimal die Reyleighlänge, bevorzugt kleiner als die Reyleighlänge und besonders bevorzugt kleiner als ein Drittel der Reyleighlänge ist. Die Wellenlänge des Laserstrahls, insbesondere des fs-Lasers, wird gemäß einer weiteren bevorzugten Ausführungsform der vorliegenden Erfindung derart gewählt, dass die Absorption des Festkörpers bzw. des Materials kleiner als 10cm⁻¹ und bevorzugt kleiner als 1cm⁻¹ und besonders bevorzugt kleiner als 0,1cm⁻¹ ist.

Die weitere Behandlung umfasst gemäß vorliegenden Erfindung die Anordnung oder Erzeugung einer Beschichtung auf mindestens einer Oberfläche des Festkörperanteils. Die vorgegebenen Parameter umfassen dabei zumindest Daten, durch welche die thermischen Ausdehnungskoeffizienten des Materials des Festkörperanteils und der Beschichtung einbezogen werden. Zusätzlich umfassen die Parameter bevorzugt Daten, durch welche die Dicke/Höhe (bevorzugt durchschnittliche Dicke/Höhe) und/oder die Breite und/oder die Länge und/oder die Form des Festkörperanteils und/oder der Beschichtung einbezogen wird/werden. Diese Ausführungsform ist vorteilhaft, da dadurch sehr präzise für unterschiedliche Materialkombinationen (Festkörper und Beschichtung) Festkörperanteile erzeugt werden können.

Der Festkörper bzw. das Werkstück weist bevorzugt ein Material oder eine Materialkombination aus einer der Hauptgruppen 3, 4 und 5 des Periodensystems der Elemente auf, wie z.B. Si, SiC, SiGe, Ge, GaAs, InP, GaN, Al2O3 (Saphir), AIN. Besonders bevorzugt weist der Festkörper eine Kombination aus in der dritten und fünften Gruppe des Periodensystems vorkommenden Elementen auf. Denkbare Materialien oder Materialkombinationen sind dabei z.B. Galliumarsenid, Silizium, Siliziumcarbid, etc. Weiterhin kann der Festkörper eine Keramik (z.B. Al2O3 - Alumiumoxid) aufweisen oder aus einer Keramik bestehen, bevorzugte Keramiken sind dabei z.B. Perovskitkeramiken (wie z.B. Pb-, O-, Ti/Zr-haltige Keramiken) im Allgemeinen und Blei-Magnesium-Niobate, Bariumtitanat, Lithiumtitanat, Yttrium-Aluminium-Granat, insbesondere Yttrium-Aluminium-Granat Kristalle für Festkörperlaseranwendungen, SAW-Keramiken (surface acoustic wave), wie z.B. Lithiumniobat, Galliumorthophosphat, Quartz, Calziumtitanat, etc. im Speziellen. Der Festkörper weist somit bevorzugt ein Halbleitermaterial oder ein Keramikmaterial auf bzw. besonders bevorzugt besteht der Festkörper aus mindestens einem Halbleitermaterial oder einem Keramikmaterial. Es ist weiterhin denkbar, dass der Festkörper ein transparentes Material aufweist oder teilweise aus einem transparenten Material, wie z.B. Saphir, besteht bzw. gefertigt ist. Weitere Materialien, die hierbei als Festkörpermaterial alleine oder in Kombination mit einem anderen Material in Frage kommen, sind z.B. "wide band gap"-Materialien, InAISb, Hochtemperatursupraleiter, insbesondere seltene Erden Cuprate (z.B. YBa2Cu3O7). Es ist zusätzlich oder alternativ denkbar, dass der Festkörper eine Photomaske ist, wobei als Photomaskenmaterial im vorliegenden Fall bevorzugt jedes zum Anmeldetag bekannte Photomaskenmaterial und besonders bevorzugt Kombinationen daraus verwendet werden können.

Gemäß einer weiteren bevorzugten Ausführungsform der vorliegenden Erfindung wird mittels der Modifikationen mehr als 5%, insbesondere mehr als 10% oder mehr als 20% oder mehr als 30% oder mehr als 40% oder mehr als 50% oder mehr als 60% oder mehr als 70% oder mehr als 80% oder mehr als 90% oder mehr als 95%, des im Verlauf des Ablösebereichs ausgebildeten Kristallgitters verändert, insbesondere beschädigt. Diese Ausführungsform ist vorteilhaft, da z.B. durch die Laserbeaufschlagung das Kristallgitter derart verändert werden kann bzw. derart Defekte, insbesondere Mikrorisse, erzeugt werden können, dass die zum Abtrennen des Festkörperanteils von dem Festkörper erforderlichen Kräfte eingestellt werden können. Es ist somit im Sinne der vorliegenden Erfindung möglich, dass die Kristallstruktur im Ablösebereich derart mittels Laserstrahlung modifiziert bzw. beschädigt wird, dass sich der Festkörperanteil infolge der Laserbehandlung vom Festkörper ablöst bzw. abgetrennt wird.

Das Ablösen des Festkörperanteils von dem Festkörper umfasst gemäß einer weiteren bevorzugten Ausführungsform der vorliegenden Erfindung zumindest die Schritte des Anordnens einer Aufnahmeschicht an dem Festkörper zum Halten des Festkörperanteils, und des thermischen Beaufschlagens der Aufnahmeschicht zum, insbesondere mechanischen, Erzeugen von Spannungen in dem Festkörper, wobei sich durch die Spannungen ein Riss in dem Festkörper entlang dem Ablösebereich ausbreitet, durch den der Festkörperanteil von dem Festkörper getrennt wird. Diese Ausführungsform ist vorteilhaft, da sehr genau und definiert Kräfte zum Abtrennen des Festkörperanteils von dem Festkörper erzeugbar sind.

Gemäß einer weiteren bevorzugten Ausführungsform der vorliegenden Erfindung weist die Aufnahmeschicht ein Polymer, insbesondere PDMS, auf oder besteht daraus, wobei die thermische Beaufschlagung derart erfolgt, dass das Polymer einen Glasübergang erfährt.

Die Aufnahmeschicht besteht bevorzugt aus Polydimethylsiloxane (PDMS) oder weist Polydimethylsiloxane (PDMS) auf.

Die thermische Beaufschlagung stellt bevorzugt ein Abkühlen der Aufnahmeschicht auf oder unter die Umgebungstemperatur und bevorzugt unter 10°C und besonders bevorzugt unter 0°C und weiter bevorzugt unter -10°C dar. Die Abkühlung der bevorzugt als Polymerschicht ausgebildeten Aufnahmeschicht erfolgt höchst bevorzugt derart, dass zumindest ein Teil der Aufnahmeschicht, die bevorzugt PDMS aufweist oder daraus besteht, einen Glasübergang vollzieht. Die Abkühlung kann hierbei eine Abkühlung auf unter -100°C sein, die z.B. mittels flüssigen Stickstoffs bewirkbar ist. Dies ist vorteilhaft, da sich die Aufnahmeschicht in Abhängigkeit von der Temperaturveränderung zusammenzieht, insbesondere einen Glasübergang erfährt, und die dabei entstehenden Kräfte auf den Festkörper überträgt, wodurch mechanische Spannungen in dem Festkörper erzeugbar sind, die zum Auslösen eines Risses und/oder zur Rissausbreitung führen.

Die Aufgabe wird ferner durch ein Verfahren zur Herstellung einer Mehrschichtanordnung gelöst. Das Verfahren zur Herstellung der Mehrschichtanordnung umfasst dabei mindestens die Schritte: Bereitstellen eines, insbesondere gewölbten, Wafers mit einer ersten unebenen Form; Anordnen oder Erzeugen einer weiteren Schicht an mindestens einer Oberfläche des Wafers; wobei die weitere Schicht und der Wafer unterschiedliche thermische Ausdehnungskoeffizienten aufweisen, wobei die weitere Schicht bei einer von einer Zieltemperatur verschiedenen Beschichtungstemperatur an der Oberfläche des Wafers angeordnet oder daran erzeugt wird, und wobei die weitere Schicht derart ausgestaltet ist, dass sie den Wafer beim Erreichen der Zieltemperatur derart beaufschlagt, dass der Wafer aus der ersten unebenen Form in eine zweite Form, die von der ersten Form abweicht, verformt wird, wobei die zweite Form bevorzugt eine ebene Form darstellt. Bevorzugt weist der unebene Festkörper einen Warp auf bzw. bildet einen Warp aus, der negativ oder im Wesentlichen negativ zu der durch die Beschichtung bewirkte Verformung des Festkörperanteils ist.

Diese Lösung ist vorteilhaft, da durch die definierte Gestaltung des Wafers vorteilhaft die infolge der Beschichtung auftretende Verformung ausgenutzt wird, um eine bevorzugt zumindest einerseits bevorzugt ebene Mehrschichtanordnung zu erhalten. Besonders bevorzugt wird die weitere Schicht mittels Epitaxie erzeugt.

Zusätzlich ist denkbar, dass der Wafer vor dem Anordnen oder Erzeugen der weiteren Schicht bereits mit einer Beschichtung versehen wurde.

Weiterhin bezieht sich die vorliegende Erfindung ebenfalls auf einen unebenen Festkörperanteil, insbesondere auf einen unebenen, insbesondere gewölbten, Wafer. Der unebene, insbesondere gewölbte, Festkörperanteil ist dabei bevorzugt nach einem Verfahren hergestellt, dass mindestens die nachfolgend genannten Schritte umfasst:
Bereitstellen eines Festkörpers zum Abtrennen des unebenen Festkörperanteils, Modifizieren des Kristallgitters des Festkörpers mittels eines Modifikationsmittels, insbesondere eines Lasers, insbesondere eines Piko- oder Femtosekunden-Laser, wobei mehrere Modifikationen zum Ausbilden eines unebenen Ablösebereichs in dem Kristallgitter erzeugt werden, wobei die Modifikationen in Abhängigkeit von vorgegebenen Parametern erzeugt werden, wobei die vorgegebenen Parameter einen Zusammenhang zwischen einer Verformung des Festkörperanteils in Abhängigkeit von einer definierten weiteren Behandlung des Festkörperanteils beschreiben, Ablösen des Festkörperanteils von dem Festkörper.

Weiterhin bezieht sich die vorliegende Erfindung besonders bevorzugt auf eine Mehrschichtanordnung. Die erfindungsgemäße Mehrschichtanordnung weist bevorzugt mindestens einen Festkörperanteil, insbesondere einen Wafer, auf, wobei der Festkörperanteil nach einem Verfahren gemäß einem der Ansprüche 1 bis 4 hergestellt ist und zunächst mindestens eine unebene Oberfläche aufweist. Weiterhin weist die Mehrschichtanordnung mindestens eine an dem Festkörperanteil angeordnete oder erzeugte Beschichtung auf, wobei die Beschichtung bei einer von einer Zieltemperatur verschiedenen Beschichtungstemperatur an dem Festkörperanteil angeordnet oder erzeugt wurde, wobei der Festkörperanteil eine Verformungsoberfläche mit einer zunächst unebenen ersten Oberflächenform aufweist, wobei der Temperaturausdehnungskoeffizient des Materials des Festkörperanteils und der Temperaturausdehnungskoeffizient des Materials der Beschichtung voneinander verschieden sind, wobei die Verformungsoberfläche des beschichteten Festkörperanteils bei der Zieltemperatur eine zweite Oberflächenform ausbildet, wobei die zweite Oberflächenform und die erste Oberflächenform voneinander verschieden sind.

Die Verwendung der Wörter "im Wesentlichen" definiert bevorzugt in allen Fällen, in denen diese Wörter im Rahmen der vorliegenden Erfindung verwendet werden eine Abweichung im Bereich von 1%-30%, insbesondere von 1%-20%, insbesondere von 1%-10%, insbesondere von 1%-5%, insbesondere von 1%-2%, von der Festlegung, die ohne die Verwendung dieser Wörter gegeben wäre.

Weitere Vorteile, Ziele und Eigenschaften der vorliegenden Erfindung werden anhand nachfolgender Beschreibung anliegender Zeichnungen erläutert, in welchen beispielhaft die erfindungsgemäße Festkörperherstellung oder Waferherstellung dargestellt ist. Bauteile oder Elemente der erfindungsgemäßen Festkörperherstellung oder Waferherstellung, welche in den Figuren wenigstens im Wesentlichen hinsichtlich ihrer Funktion übereinstimmen, können hierbei mit gleichen Bezugszeichen gekennzeichnet sein, wobei diese Bauteile oder Elemente nicht in allen Figuren beziffert oder erläutert sein müssen.

Darin zeigen:
- Fig. 1a: einen schematischen Aufbau zum Erzeugen von Defekten in einem Festkörper;
- Fig. 1b: eine schematische Darstellung einer Schichtanordnung vor dem Abtrennen einer Festkörperschicht von einem Festkörper;
- Fig. 1c: eine schematische Darstellung einer Schichtanordnung nach dem Abtrennen einer Festkörperschicht von einem Festkörper;
- Fig. 2a: eine erste schematisch dargestellte Variante zur Defekterzeugung mittels Laserstrahlung;
- Fig. 2b: eine zweite schematisch dargestellte Variante zur Defekterzeugung mittels Laserstrahung;
- Fig. 3a: eine schematische Seitenansicht eines erfindungsgemäßen unebenen Wafers;
- Fig. 3b: eine schematische Seitenansicht eines erfindungsgemäßen unebenen Wafers mit einer daran angeordneten oder erzeugten Beschichtung; und
- Fig. 3c: eine schematische Seitenansicht einer bevorzugten Form einer erfindungsgemäßen Mehrschichtanordnung nach einer definierten Temperierung.

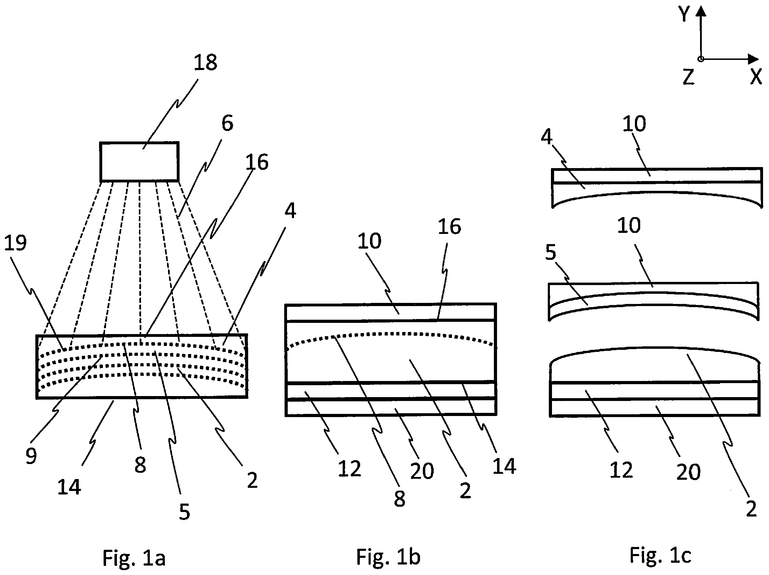

In Fig. 1a ist ein Festkörper 2 bzw. ein Substrat gezeigt, das im Bereich einer Strahlungsquelle 18, insbesondere einem Laser, angeordnet ist. Der Festkörper 2 weist bevorzugt einen ersten ebenen Flächenanteil 14 und einen zweiten ebenen Flächenanteil 16 auf, wobei der erste ebene Flächenanteil 14 bevorzugt im Wesentlichen oder genau parallel zu dem zweiten ebenen Flächenanteil 16 ausgerichtet ist. Der erste ebene Flächenanteil 14 und der zweite ebene Flächenanteil 16 begrenzen bevorzugt den Festkörper 2 in einer Y-Richtung, die bevorzugt vertikal bzw. lotrecht ausgerichtet ist. Die ebenen Flächenanteile 14 und 16 erstrecken sich bevorzugt jeweils in einer X-Z-Ebene, wobei die X-Z-Ebene bevorzugt horizontal ausgerichtet ist. Alternativ ist jedoch denkbar, dass der erste und/oder der zweite Flächenanteil 14, 16 eine unebene, insbesondere gewölbte, Form aufweist.

Weiterhin lässt sich dieser Darstellung entnehmen, dass die Strahlungsquelle 18 Stahlen 6 auf den Festkörper 2 ausstrahlt. Die Strahlen 6 dringen je nach Konfiguration bzw. in Abhängigkeit von vorgegebenen Parametern definiert tief in den Festkörper 2 ein und erzeugen an der jeweiligen Position bzw. an der jeweils vorbestimmten Position eine Kristallgittermodifikation 19, insbesondere einen Defekt. Bevorzugt werden so viele Modifikationen bzw. Kristallgittermodifikationen 19 erzeugt, dass durch diese mindestens ein Ablösebereich 8 vorgegeben wird. Der Ablösebereich 8 weist eine unebene Kontur bzw. unebene Form auf, wobei der Ablösebereich 8 besonders bevorzugt zumindest abschnittsweise eine sphärische, insbesondere gewellte und/oder gewölbte und/oder gebogene, Form aufweist. Weiterhin können die Strahlen 6 z.B. zum Fokussieren oder Bündeln durch eine Optik geleitet werden, die bevorzugt zwischen der Strahlungsquelle 18 und dem Festkörper 2 angeordnet ist (nicht gezeigt).

Das Bezugszeichen 9 kennzeichnet einen weiteren Ablösebereich in dem Festkörper 2. Gemäß der vorliegenden Erfindung kann der weitere Ablösebereich 9 ebenfalls während der Erzeugung des Ablösebereichs 8 erzeugt werden. Alternativ ist denkbar, dass der weitere Ablösebereich 9 nach oder vor der Erzeugung des Ablösebereichs 8 erzeugt wird. Bevorzugt wird der weitere Ablösebereich 9 nach dem Abtrennen des Festkörperanteils 4 oder vor dem Abtrennen des Festkörperanteils 4 erzeugt. Bevorzugt werden durch mehrere Ablösebereiche 8, 9 in einem Festkörper 2 mehrere Festkörperanteile 4, 5 definiert, die bevorzugt nacheinander von dem Festkörper 2 abtrennbar sind. Gemäß einer bevorzugten Ausführungsform der vorliegenden Erfindung wird in einem Festkörper 2 genau oder mindestens ein Ablösebereich 8 erzeugt. Gemäß einer weiteren bevorzugten Ausführungsform der vorliegenden Erfindung werden zwei, mindestens zwei oder genau zwei oder drei, mindestens drei oder genau drei oder vier, mindestens vier oder genau vier oder fünf, mindestens fünf oder genau fünf oder mehrere, insbesondere z.B. bis zu 10 oder 25 oder 50 oder 100 oder 500, Ablösebereiche in dem Festkörper 2 erzeugt.

In Fig. 1b ist eine mehrschichtige Anordnung gezeigt, wobei der Festkörper 2 den Ablösebereich 8 beinhaltet und im Bereich des ersten Flächenanteils 14 mit einer Halteschicht 12 versehen ist, die wiederum bevorzugt von einer weiteren Schicht 20 überlagert wird, wobei die weitere Schicht 20 bevorzugt eine Stabilisierungseinrichtung, insbesondere eine Metallplatte, ist. An dem zweiten Flächenanteil 16 des Festkörpers 2 ist bevorzugt eine Aufnahmeschicht, insbesondere eine Polymerschicht 10, angeordnet. Die Aufnahmeschicht 10 und/oder die Halteschicht 12 bestehen bevorzugt zumindest teilweise und besonders bevorzugt vollständig aus einem Polymer, insbesondere aus PDMS. Alternativ ist denkbar, dass die Aufnahmeschicht 10 z.B. mittels Epitaxie auf der Oberfläche des Festkörpers 2 erzeugt wird. Bevorzugt weisen die erzeugte Aufnahmeschicht 10 und der Festkörper 2 voneinander verschiedene Temperaturausdehnungskoeffizienten auf. Nach der Erzeugung der Aufnahmeschicht 10, die in diesem Fall auch als Beschichtung 50 verstanden werden kann, erfolgt bevorzugt eine Abkühlung der geschaffenen Mehrschichtanordnung, wodurch sich aufgrund der unterschiedlichen thermischen Ausdehnungskoeffizienten Spannungen ergeben, durch welche der Festkörperanteil 4 von dem Festkörper 2 entlang dem Ablösebereich 8 abgetrennt bzw. abgelöst wird.

In Fig. 1c ist ein Zustand nach einer Rissauslösung und anschließender Rissführung gezeigt. Die Festkörperschicht 4 haftet an der Polymerschicht 10 und ist von dem verbleibenden Rest des Festkörpers 2 beabstandet bzw. beabstandbar.

Weiterhin können gemäß der vorliegenden Erfindung unterschiedliche Ablösebereiche 8, 9 unterschiedliche Formen bzw. Konturen aufweisen. Weiterhin ist denkbar, dass z.B. der zweite Flächenanteil 16, der eine Oberfläche des später abgetrennten Festkörperanteils 4, 5 ist, vor dem Abtrennen des Festkörperanteils 4, 5 in eine andere Form gebracht wird. Diese Formänderung kann analog zum Abtrennen des Festkörperanteils 4, 5 erfolgen oder durch eine spanende Bearbeitung, insbesondere einen Schleifprozess, bewirkt werden.

Die vorliegende Erfindung bezieht sich somit auf ein Verfahren zum Herstellen von Festkörperschichten. Das erfindungsgemäße Verfahren umfasst dabei mindestens die Schritte des Bereitstellens eines Festkörpers 2 zum Abtrennen mindestens einer Festkörperschicht 4, des Erzeugens von Modifikationen, wie Kristallgitterdefekten, mittels mindestens einem Laser, insbesondere mindestens einem fs-Laser, in der inneren Struktur des Festkörpers zum Vorgeben mindestens eines Ablösebereichs 8, 9, entlang dem die Festkörperschicht/en 4, 5 vom Festkörper 2 abgetrennt wird, werden. Ferner umfasst das erfindungsgemäße Verfahren bevorzugt den Schritt des thermischen Beaufschlagens einer an dem Festkörper 2 angeordneten Polymerschicht 10 zum, insbesondere mechanischen, Erzeugen von Spannungen in dem Festkörper 2, wobei sich durch die Spannungen ein Riss in dem Festkörper 2 entlang des Ablösebereichs 8 ausbreitet, der die Festkörperschicht 4 von dem Festkörper 2 abtrennt.

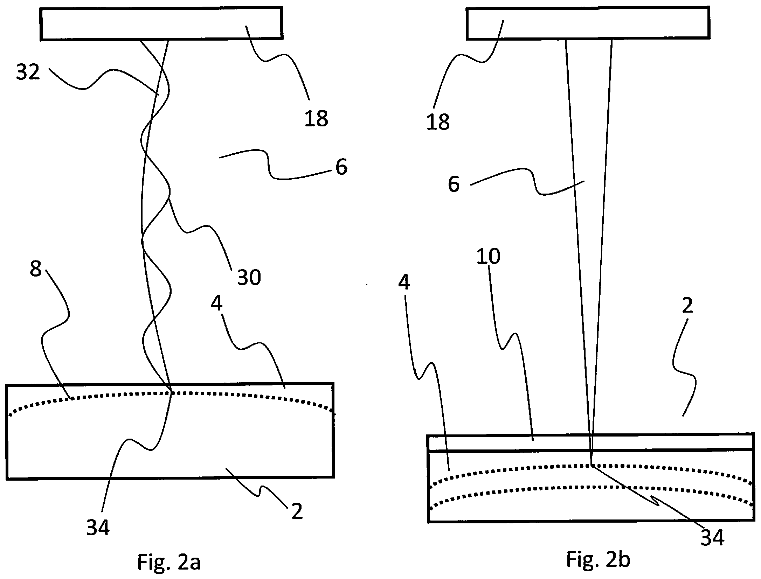

In den Figuren 2a und 2b sind Beispiele für die in Fig. 1a gezeigte Erzeugung eines Ablösebereichs 8 durch die Einbringung von Modifikationen 19, insbesondere Defekten oder Schadstellen, in einen Festkörper 2 mittels Laserstrahlen 6 gezeigt.

In Fig. 2a ist somit schematisch gezeigt, wie Modifikationen 19 in einem Festkörper 2, insbesondere zur Erzeugung eines Ablösebereichs 8 mittels einer Strahlungsquelle 18, insbesondere einem oder mehrerer Laser, insbesondere einem oder mehrerer fs-Laser, erzeugbar sind. Die Strahlungsquelle 18 emittiert dabei Strahlung 6 mit einer ersten Wellenlänge 30 und einer zweiten Wellenlänge 32. Die Wellenlängen 30, 32 sind dabei derart aufeinander abgestimmt bzw. die Distanz zwischen der Strahlungsquelle 18 und des zu erzeugenden Ablösebereichs 8 ist derart abgestimmt, dass die Wellen 30, 32 im Wesentlichen oder genau auf dem Ablösebereich 8 in dem Festkörper 2 zusammentreffen, wodurch am Ort des Zusammentreffens 34 infolge der Energien beider Wellen 30, 32 ein Defekt erzeugt wird. Die Defekterzeugung kann dabei durch unterschiedliche oder kombinierte Zersetzungsmechanismen wie z.B. Sublimation oder chemische Reaktion erfolgen, wobei die Zersetzung dabei z.B. thermisch und/oder photochemisch initiiert werden kann.

In Fig. 2b ist ein fokussierter Lichtstrahl 6 gezeigt, dessen Brennpunkt bevorzugt im Ablösebereich 8 liegt. Es ist hierbei denkbar, dass der Lichtstrahl 6 durch eine oder mehrere fokussierende Körper, insbesondere Linseln (nichtgezeigt), fokussiert wird.

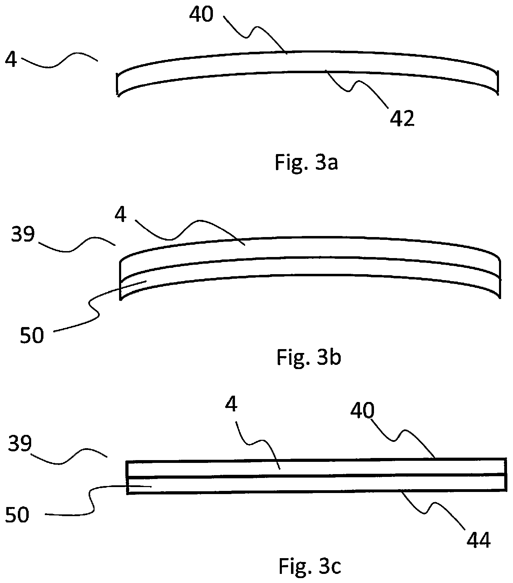

In Fig. 3a ist ein erfindungsgemäßer unebener Festkörperanteil 4 oder ein unebener Wafer dargestellt, wobei der Festkörperanteil 4 oder der Wafer 4 gemäß einer Darstellung ein Warp ausbildet bzw. im Querschnitt eine Warpform zeigt. Es ist hierbei denkbar, dass der Festkörperanteil 4 zwei zueinander negativ ausgebildete Oberflächenkonturen bzw. Oberflächenformen aufweist. Es ist jedoch ebenfalls denkbar, dass die Oberflächenkonturen bzw. Oberflächenformen der zwei einander gegenüberliegenden Hauptoberflächen 40, 42 des Festkörperanteils 4 nicht negativ zueinander ausgebildet sind, sondern voneinander verschiedene Konturen bzw. Formen aufweisen.

Fig. 3b zeigt die Erzeugung einer Beschichtung 50, insbesondere eine epitaktisch erzeugten Schicht. Die Beschichtung 50 wird bevorzugt bei einer Temperatur von über 50°C, insbesondere über 100°C oder über 150°C oder über 200°C oder über 300°C oder über 400°C, auf dem Festkörperanteil 4 angeordnet oder erzeugt. Es ist hierbei denkbar, dass die Beschichtung 50 im Wesentlichen oder mit einer konstanten Dicke auf dem Festkörperanteil 4 angeordnet oder erzeugt wird. Alternativ ist jedoch ebenfalls denkbar, dass die Beschichtung 50 lokal verschiedene Dicken aufweist. Die weitere Behandlung stellt somit die Anordnung oder Erzeugung einer definierten Beschichtung 50 auf mindestens einer Oberfläche 40, 42 des Festkörperanteils 4 dar. Die vorgegebenen Parameter umfassen dabei zumindest Daten, durch die zumindest mittelbar die thermischen Ausdehnungskoeffizienten des Materials des Festkörperanteils 4 und der Beschichtung 50 einbezogen werden oder durch die eine Verformung des Festkörperanteils 4 infolge einer definierten Temperierung des mit der Beschichtung 50 versehenen Festkörperanteils 4 einbezogen oder vorgegeben wird.

In Fig. 3c ist eine Situation nach der Erzeugung oder Anordnung der Beschichtung 50 an mindestens einer Oberfläche 40, 42 des Festkörperanteils 4 gezeigt, wobei sich die Form der erzeugten Mehrkomponentenanordnung 39 aufgrund von unterschiedlichen thermischen Ausdehnungskoeffizienten verändert hat. Bevorzugt ist zumindest eine der Hauptoberflächen 40 und 44 der Mehrkomponentenanordnung 39 bzw. Mehrschichtanordnung in eine ebene oder im Wesentlichen ebene Form überführt. Die Verformung ergibt sich bevorzugt in Folge einer bevorzugt definierten Temperierung, insbesondere Erwärmung oder Abkühlung, der Mehrschichtanordnung 39.

Der Festkörperanteil 4 ist somit erfindungsgemäß derart in Abhängigkeit von dem nachgelagerten Behandlungsverfahren, insbesondere Beschichtungsverfahren, gestaltet, dass sich die Form einer oder beider Hauptoberflächen 40, 42 des Festkörperanteils 4 infolge der Behandlung, insbesondere des Beschichtungsverfahrens, definiert verändert, insbesondere abflacht oder eben ausbildet. Besonders bevorzugt handelt es sich bei der Beschichtung um eine Metallschicht oder eine Halbleiterschicht, insbesondere um eine Galliumnitridschicht (GaN) oder Siliziumschicht, die auf einem Festkörperanteil aus Silizium, Saphir, Siliziumcarbid (SiC) oder Galliumarsenid (GaAs) angeordnet oder erzeugt wird.

### Bezugszeichenliste

- 2: Festkörper
- 4: Festkörperanteil
- 5: weiterer Festkörperanteil
- 6: Strahlung
- 8: Ablösebereich
- 9: weiterer Ablösebereich
- 10: Aufnahmeschicht
- 12: Halteschicht
- 14: erster Flächenanteil
- 16: zweiter Flächenanteil
- 18: Strahlungsquelle
- 19: Modifikation
- 20: Stabilisierungseinrichtung
- 30: erster Strahlungsanteil
- 32: zweiter Strahlungsanteil
- 34: Ort der Defekterzeugung
- 40: erste Hauptoberfläche des Festkörperanteils
- 42: zweite Hauptoberfläche des Festkörperanteils
- 44: zweite Hauptoberfläche der Mehrkomponentenanordnung
- 50: Beschichtung

- X: erste Richtung
- Y: zweite Richtung
- Z: dritte Richtung

## Patentansprüche

1. Verfahren zum Abtrennen mindestens eines Festkörperanteils (4), insbesondere eines Wafers, von einem Festkörper (2) mindestens umfassend die Schritte:
Modifizieren des Kristallgitters des Festkörpers (2) mittels eines Modifikationsmittels (18), wobei mehrere Modifikationen (19) zum Ausbilden eines unebenen, insbesondere gewölbten, Ablösebereichs (8) im Inneren des Festkörpers (2) erzeugt werden,
Ablösen des Festkörperanteils (4) von dem Festkörper (2) entlang des Ablösebereichs, und
definierte weitere Behandlung des Festkörperanteils (4), die zu einer Verformung des Festkörperanteils (4) führt,
wobei die Positionen der Modifikationen (19) in Abhängigkeit von vorgegebenen Parametern erzeugt werden, die einen Zusammenhang zwischen der Verformung des Festkörperanteils (4) in Abhängigkeit von der definierten weiteren Behandlung des Festkörperanteils (4) beschreiben,
wobei die Modifikationen (19) innerhalb des Kristallgitters des Festkörpers (2) mittels über eine äußere Oberfläche des Festkörperanteils (4) in das Innere des Festkörperanteils (4) eingeleitete Strahlung (6) mindestens eines Lasers, insbesondere eines Piko- oder Femtosekunden-Lasers, erzeugt werden,
wobei weitere Behandlung des Festkörperanteils die Anordnung oder Erzeugung einer definierten Beschichtung (50) auf mindestens einer Oberfläche (40, 42) des Festkörperanteils (4) umfasst, und
**dadurch gekennzeichnet dass**
die vorgegebenen Parameter zumindest Daten umfassen, durch die zumindest mittelbar die thermischen Ausdehnungskoeffizienten des Materials des Festkörperanteils (4) und der Beschichtung (50) einbezogen werden oder durch die eine Verformung des Festkörperanteils (4) infolge einer definierten Temperierung des mit der Beschichtung (50) versehenen Festkörperanteils (4) einbezogen oder vorgegeben wird.

2. Verfahren nach einem der vorangegangenen Ansprüche,
wobei mittels der Modifikationen (19) mehr als 5%, insbesondere mehr als 10% oder mehr als 20% oder mehr als 50% oder mehr als 80%, des im Verlauf des Ablösebereichs (8) ausgebildeten Kristallgitters verändert, insbesondere beschädigt, wird.

3. Verfahren nach Anspruch 1 oder 2,
wobei das Ablösen des Festkörperanteils (4) von dem Festkörper (2) zumindest die nachfolgend genannten Schritte umfasst:
Anordnen einer Aufnahmeschicht (10) an dem Festkörper (2) zum Halten des Festkörperanteils (4), und
thermisches Beaufschlagen der Aufnahmeschicht (10) zum, insbesondere mechanischen, Erzeugen von Spannungen in dem Festkörper (2),
wobei sich durch die Spannungen ein Riss in dem Festkörper (2) entlang dem Ablösebereich (8) ausbreitet, durch den der Festkörperanteil (4) von dem Festkörper (2) getrennt wird.

4. Verfahren nach Anspruch 3,
wobei die Aufnahmeschicht (10) ein Polymer, insbesondere PDMS, aufweist oder daraus besteht, und
wobei die thermische Beaufschlagung derart erfolgt, dass das Polymer einen Glasübergang erfährt.

## Claims

1. Method for separating at least one solid-state component (4), in particular a wafer, from a solid-state body (2), at least comprising the steps of:
modifying the crystal lattice of the solid-state body (2) by means of a modification means (18), wherein a plurality of modifications (19) are generated so as to form a non-planar, in particular curved, detachment region (8) in the interior of the solid-state body (2),
detaching the solid-state component (4) from the solid-state body (2) along the detachment region, and
further treating the solid-state component (4) in a defined manner, leading to a deformation of the solid-state component (4),
wherein the positions of the modifications (19) are generated in dependence on predefined parameters which describe a relationship between the deformation of the solid-state component (4) in dependence on the defined further treatment of the solid-state component (4),
wherein the modifications (19) within the crystal lattice of the solid-state body (2) are generated by means of radiation (6) from at least one laser, in particular a picosecond or femtosecond laser, introduced via an outer surface of the solid-state component (4) into the interior of the solid-state component (4),
wherein further treatment of the solid-state component comprises the arrangement or generation of a defined coating (50) on at least one surface (40, 42) of the solid-state component (4), and
**characterized in that**
the predefined parameters at least comprise data which include, at least indirectly, the thermal expansion coefficients of the material of the solid-state component (4) and of the coating (50) or which include or predefine a deformation of the solid-state component (4) as a result of a defined temperature control of the solid-state component (4) provided with the coating (50).

2. Method according to one of the preceding claims,
wherein more than 5%, in particular more than 10% or more than 20% or more than 50% or more than 80%, of the crystal lattice formed in the profile of the detachment region (8) is changed, in particular damaged, by the modifications (19).

3. Method according to Claim 1 or 2,
wherein the detachment of the solid-state component (4) from the solid-state body (2) comprises at least the following steps:
arranging a receiving layer (10) on the solid-state body (2) for holding of the solid-state component (4), and
subjecting the receiving layer (10) to thermal stress for, in particular mechanical, generation of stresses in the solid-state body (2),
wherein, as a result of the stresses, a crack in the solid-state body (2) propagates along the detachment region (8), by means of which the solid-state component (4) is separated from the solid-state body (2).

4. Method according to Claim 3,
wherein the receiving layer (10) comprises or consists of a polymer, in particular PDMS, and
wherein the thermal stress is effected in such a way that the polymer undergoes a glass transition.

## Revendications

1. Procédé pour séparer au moins une partie (4), en particulier une tranche, d'un corps (2) solide comprenant au moins les stades :
modification du réseau cristallin du corps (2) solide, à l'aide d'un moyen (18) de modification, dans lequel on produit plusieurs modifications (19) pour la formation, à l'intérieur du corps (2) solide, d'une région (8) de détachement non plane, en particulier cintrée,
détachement de la partie (4) du corps (2) solide le long de la région de détachement, et
autre traitement défini de la partie (4) du corps solide, qui conduit à une déformation de la partie (4) du corps solide,
dans lequel on produit les positions des modifications (19), en fonction de paramètres donnés à l'avance, qui décrivent une relation entre la déformation de la partie (4) du corps solide en fonction de l'autre traitement défini de la partie (4) du corps solide, dans lequel on produit les modifications (19) au sein du réseau cristallin du corps (2) solide, au moyen d'un rayonnement (6) d'au moins un laser, en particulier d'un laser à piko secondes ou à femto secondes, envoyé par une surface extérieure de la partie (4) du corps solide, à l'intérieur de la partie (4) du corps solide,
dans lequel un autre traitement de la partie du corps solide comprend mettre ou produire un revêtement (50) défini sur au moins une surface (40, 42) de la partie (4) du corps solide, et
**caractérisé en ce que** les paramètres donnés à l'avance comprennent au moins des données, par lesquelles, au moins indirectement, les coefficients de dilatation thermique du matériau de la partie (4) du corps solide et du revêtement (50) sont inclus, ou par lesquelles une déformation de la partie (4) du corps solide, en raison d'une mise en température définie de la partie (4) du corps solide pourvue du revêtement (50), est incluse ou donnée à l'avance.

2. Procédé suivant l'une des revendications précédentes,
dans lequel, au moyen des modifications (19) plus de 5%, en particulier plus de 10%, ou plus de 20%, ou plus de 50 %, ou plus de 80% du réseau cristallin, formé dans le tracé de la région (8) de détachement, est modifié, en étant en particulier endommagé.

3. Procédé suivant la revendication 1 ou 2,
dans lequel le détachement de la partie (4) du corps (2) solide comprend au moins les stades mentionnés ci-dessous :
mise d'une couche (10) de réception sur le corps (2) solide pour retenir la partie (4) du corps solide, et
sollicitation thermique de la couche (10) de réception pour la production, en particulier mécanique, de tensions dans le corps (2) solide,
dans lequel par les tensions, une fissure dans le corps (2) solide se propage le long de la région (8) de détachement, par laquelle la partie (4) du corps solide est séparée du corps (2) solide.

4. Procédé suivant la revendication 3,
dans lequel la couche (10) de réception a un polymère, notamment du PDMS, ou en est constituée, et
dans lequel la sollicitation thermique s'effectue de manière à ce que le polymère subisse une transition à l'état vitreux.
